# EUROPÄISCHE PATENTSCHRIFT

(11) **EP 3 857 615 B1**
(45) Veröffentlichungstag und Bekanntmachung des Hinweises auf die Patenterteilung: **26.03.2025**
(21) Anmeldenummer: 19778933.2
(22) Anmeldetag: 24.09.2019
(51) Int. Cl.: H01L 31/068, H01L 31/18

(54) **HALBLEITERBAUELEMENT UND VERFAHREN ZUM VEREINZELN EINES HALBLEITERBAUELEMENTS MIT EINEM PN-ÜBERGANG**
SEMICONDUCTOR COMPONENT AND METHOD FOR SINGULATING A SEMICONDUCTOR COMPONENT HAVING A PN JUNCTION
COMPOSANT SEMI-CONDUCTEUR ET PROCÉDÉ DE SÉPARATION D'UN COMPOSANT SEMI-CONDUCTEUR AVEC UNE TRANSITION PN

(30) Priorität: 24.09.2018 DE 102018123485
(43) Veröffentlichungstag der Anmeldung: 04.08.2021
(73) Patentinhaber: Fraunhofer-Gesellschaft zur Förderung der angewandten Forschung e.V., 80686 München (DE)
(72) Erfinder: LOHMÜLLER, Elmar, 79110 Freiburg (DE); PREU, Ralf, 79110 Freiburg (DE); BALIOZIAN, Puzant, 79110 Freiburg (DE); FELLMETH, Tobias, 79110 Freiburg (DE); WÖHRLE, Nico, 79110 Freiburg (DE); SAINT-CAST, Pierre, 79110 Freiburg (DE); RICHTER, Armin, 79110 Freiburg (DE)
(74) Vertreter: LBP Lemcke, Brommer & Partner Patentanwälte mbB
(86) Internationale Anmeldenummer: PCT/EP2019/075603
(87) Internationale Veröffentlichungsnummer: WO 2020/064670

(56) Entgegenhaltungen:
- US-A1- 2012 161 266
- US-A1- 2013 203 239
- NICO WÖHRLE ET AL: "Solar cell demand for bifacial and singulated-cell module architectures", PHOTOVOLTAICS INTERNATIONAL, vol. 36, 16 June 2017 (2017-06-16), pages 48 - 62, XP055764378
- HERMLE M ET AL: "Analysis of edge recombination for high-efficiency solar cells at low illumination densities", PROCEEDINGS OF THE 3RD WORLD CONFERENCE ON PHOTOVOLTAIC ENERGY CONVERSION : JOINT CONFERENCE OF 13TH PV SCIENCE & ENGINEERING CONFERENCE, 30TH IEEE PV SPECIALISTS CONFERENCE, 18TH EUROPEAN PV SOLAR ENERGY CONFERENCE; OSAKA INTERNATIONAL CONGRESS CENT, 18 May 2003 (2003-05-18), pages 1009, XP031987936, ISBN: 978-4-9901816-0-4
- STEFAN EITERNICK ET AL: "High Quality Half-cell Processing Using Thermal Laser Separation", ENERGY PROCEDIA, vol. 77, 1 August 2015 (2015-08-01), NL, pages 340 - 345, XP055271630, ISSN: 1876-6102, DOI: 10.1016/j.egypro.2015.07.048
- WEINHOLD S ET AL: "Study of fast laser induced cutting of silicon materials", VISUAL COMMUNICATIONS AND IMAGE PROCESSING; 20-1-2004 - 20-1-2004; SAN JOSE,, vol. 8967, 6 March 2014 (2014-03-06), pages 89671J - 89671J, XP060034447, ISBN: 978-1-62841-730-2, DOI: 10.1117/12.2039819

## Beschreibung

Die Erfindung betrifft ein Halbleiterbauelement gemäß Anspruch 1 sowie ein Verfahren zum Vereinzeln eines Halbleiterbauelements mit einem pn-Übergang gemäß Anspruch 6.

Bei der Herstellung von Halbleiterbauelementen ist es häufig wünschenswert, mehrere auf einem Substrat hergestellte Halbleiterbauelemente zu vereinzeln, indem das Substrat an zumindest einer Trennfläche aufgetrennt wird, sodass die Halbleiterbauelemente separiert sind. Ein solches Vereinzeln ist bei der Herstellung von Rechenprozessoren notwendig, da typischerweise eine Vielzahl von Rechenprozessoren auf einem Siliziumwafer hergestellt werden. Darüber hinaus findet ein Vereinzeln von fotovoltaischen Solarzellen zunehmend Anwendung:
Fotovoltaische Module werden heute üblicherweise aus Silizium-Solarzellen mit einer Kantenlänge von ca. 156 mm hergestellt. Die Verschaltung erfolgt durch elektrisch leitende Verbindungen mittels leitenden Elementen - meist sogenannten Zellverbindern -, die jeweils Solarzellen alternierend auf Vorder- und Rückseite verbinden. Ein Nachteil dieser Verschaltung ist, dass der hohe Strom (bis ca. 10 A) der einzelnen Solarzellen eine sehr hohe Leitfähigkeit und somit hohe Leitungsquerschnitte der Zellverbinder voraussetzen.

Eine bekannte Möglichkeit diesen Nachteil zu umgehen ist, auf einem Siliziumwafer zwei oder mehr Solarzellen vorzusehen, um den Strom pro Solarzelle entsprechend proportional zu senken. Diese werden erst zum Ende der Prozessierung vereinzelt, um möglichst lange im Nutzen der großen Ausgangswafer zu produzieren und somit die Produktivität hoch zu halten und etabliertes Produktionsequipment verwenden zu können.

Werden die Solarzellen weiterhin wie oben beschrieben mittels Zellverbinder elektrisch verbunden, so verbleibt zwischen den Solarzellen Raum, der nicht fotovoltaisch aktiv ist und deshalb zu einer Reduktion des Modulwirkungsgrades führt.

Eine bekannte Methode, diesen Nachteil zu umgehen, ist das sogenannte Verschindeln der Solarzellen, bei dem die Oberseite eines Endes einer Solarzelle unmittelbar elektrisch mit der Unterseite der nächsten Zelle verbunden wird. Hierfür werden die externen Kontakte auf der Vorder- und Rückseite an den jeweils gegenüberliegenden Kanten der Solarzellen realisiert. Da üblicherweise zwecks Minimierung der Abschattung keine sehr hoch leitenden Kontaktelemente in der Solarzelle vorhanden sind und für das Schindelkonzept basierend auf großen konventionellen Solarzellen die Strecken, durch die der Strom in den Kontaktfingern zu den außen liegenden externen Kontakten fließen muss, sehr groß werden, werden die Siliziumwafer nach Prozessierung der Solarzellen in schmale Streifen geschnitten, sodass somit mehrere fotovoltaische Solarzellen mit einer typischerweise rechteckigen Form realisiert werden, um beim Verschindeln Leistungsverluste in den Fingerkontakten der Solarzelle zu minimieren.

Die Vereinzelung der auf einem Substrat, insbesondere einem Siliziumwafer hergestellten Halbleiterbauelemente führt zu einer Vergrößerung des Verhältnisses aus Umfang zu Fläche und somit zu einem Ansteigen von flächennormierten Leistungsverlusten durch Randrekombination. Untersuchungen haben gezeigt (J. Dicker, "Analyse und Simulation von hocheffizienten Silizium-Solarzellenstrukturen für industrielle Fertigungstechniken", Dissertation, Universität Konstanz, 2003), dass insbesondere der Bereich, in welchem ein pn-Übergang an eine Trennfläche, an welcher eine Vereinzelung erfolgte, auftrifft, zu Leistungsverlusten führt. Ein Grund hierfür ist insbesondere die Randrekombination in den quasi neutralen Gebieten von Emitter und Basis und wie zuvor beschrieben insbesondere in der Raumladungszone. Hinzu kommt, dass die Trennung der vereinzelten Halbleiterbauelemente an den erzeugten Kanten zu einer deutlichen Erhöhung der Rekombinationsrate selbst führt. Dieser Einfluss ist insbesondere dann relevant, wenn das Halbleiterbauelement an den anderen Oberflächen eine hohe elektronische Güte, insbesondere eine niedrigere Rekombinationsrate durch Passivierungsschichten oder anderen Passivierungsmechanismen aufweist.

Es besteht daher ein Bedarf, Halbleiterbauelemente zu vereinzeln, ohne die elektronische Güte des Halbleiterbauelementes durch die Trennfläche, insbesondere durch Rekombinationseffekte an der Trennfläche, wesentlich zu verringern.

Es ist bekannt, dass bei Silizium-Solarzellen eine an der Trennfläche nativ aufwachsende Siliziumdioxidschicht bei geringen Beleuchtungsstärken den negativen Einfluss verringert (M. Hermle, J. Dicker, W. Warta, S. W. Glunz and G. Willeke, "Analysis of edge recombination for high-efficiency solar cells at low illumination densities", 2003, pp. 1009-1012.). Bei Silizium-Solarzellen unter Normbeleuchtung wird hierdurch jedoch nur eine geringfügige Verbesserung erzielt. Nico Wöhrle et al.: "Solar cell demand for bifacial and singulated-cell module architectures", Photovoltaics International, Bd. 36, 16. Juni 2017, Seiten 48-62, offenbart Solarzellenmodulen, welche mit streifenartigen Solarzellen ausgebildet werden, welche durch Vereinzeln der Solarzellen ausgehend von einem Solarzellensubstrat erzielt werden.

Der vorliegenden Erfindung liegt daher die Aufgabe zugrunde, ein Halbleiterbauelement sowie ein Verfahren zum Vereinzeln eines Halbleiterbauelementes zur Verfügung zu stellen, sodass ein negativer Einfluss der Trennfläche auf die elektronische Güte verringert wird.

Gelöst ist diese Aufgabe durch ein Halbleiterbauelement gemäß Anspruch 1 sowie ein Verfahren gemäß Anspruch 6. Vorteilhafte Ausführungsformen finden sich in den abhängigen Ansprüchen.

Das erfindungsgemäße Verfahren ist bevorzugt zum Herstellen eines erfindungsgemäßen Halbleiterbauelementes, insbesondere einer bevorzugten Ausführungsform hiervon, ausgebildet. Das erfindungsgemäße Halbleiterbauelement ist bevorzugt mittels des erfindungsgemäßen Verfahrens, insbesondere einer bevorzugten Ausführungsform hiervon, ausgebildet.

Das erfindungsgemäße Halbleiterbauelement weist eine Vorder- und eine gegenüberliegende Rückseite sowie Seitenflächen auf. Weiterhin weist das Halbleiterbauelement zumindest einen Emitter und zumindest eine Basis auf, wobei zwischen Emitter und Basis ein pn-Übergang ausgebildet ist. Der Emitter erstreckt sich parallel zu der Vorder- und/oder Rückseite. Das Halbleiterbauelement ist als fotovoltaische Solarzelle ausgebildet. Der Emitter kann in an sich bekannter Weise ausgebildet sein.

Insbesondere liegen mittels Diffusion und/oder Implantation erzeugte Emitter sowie Heteroemitter und epitaktisch erzeugte Emitter im Rahmen der Erfindung.

Wesentlich ist, dass zumindest eine Seitenfläche eine Trennfläche ist, an der eine Trennflächenpassivierungsschicht angeordnet ist. Die Trennflächenpassivierungsschicht weist ortsfeste Ladungen mit einer Flächenladungsdichte im Betrag größer gleich 10¹² cm⁻² auf. Die Flächenladungsdichte kann somit elektrisch positiv oder negativ sein. Wesentlich ist, dass der Betrag der Flächenladungsdichte größer gleich 10¹² cm⁻² ist, d.h. bei einer positiven Ladung größer gleich 10¹² cm⁻² und bei einer negativen Ladung kleiner gleich -1×10¹² cm⁻².

Die Erfindung ist in der Erkenntnis begründet, dass die negativen Effekte, welche an einer Trennfläche auftreten, besonders effizient durch eine Trennflächenpassivierungsschicht mit einer Flächenladungsdichte im Betrag her ≥ 10¹² cm⁻² verringert werden können. Zwar sind an sich bei Halbleiterbauelementen und insbesondere bei fotovoltaischen Solarzellen Passivierungsschichten bekannt, welche die Oberflächenrekombinationsgeschwindigkeit von Ladungsträgern verringern. Untersuchungen der Anmelderin zeigen jedoch, dass die negativen Effekte an der Trennfläche besonders effizient durch die zuvor beschriebene Trennflächenpassivierungsschicht verringert werden. Das ist vor allem darin begründet, dass ortsfeste Ladungen in der Trennflächenpassivierungsschicht Ladungsträger im Halbleiterbauelement, insbesondere einer Siliziumschicht des Halbleiterbauelementes, abhalten, an die Trennfläche zu gelangen. Insbesondere bei einer Siliziumschicht werden diese bis zu einer Tiefe von etwa 20 nm ins Silicium von der Trennfläche abgehalten. Das hat zum Vorteil, dass eine oberflächennahe Schädigung an der Trennfläche verursacht durch den Trennungsprozess bis zu einer Tiefe von etwa 20 nm tolerierbar ist. Ein mechanisches Trennen ist ohne Schädigung mehrerer Atomlagen der Oberfläche des Halbleitervolumens in der Regel nicht möglich. Es lässt sich aber durch geeignete Prozesswahl auf eine Tiefe kleiner 20 nm beschränken. Vorteilhafterweise wird das Verfahren deshalb so ausgeführt, dass das Auftrennen mittels eines der nachfolgend erläuterten Verfahren TLS, LIC oder LDC erfolgt, da diese Verfahren eine vergleichsweise geringe Schädigungstiefe aufweisen.

Vorteilhafterweise überdeckt die Trennflächenpassivierungsschicht zumindest den Bereich, in welchem der pn-Übergang an die Trennfläche angrenzt.

Eine besonders vorteilhafte Passivierung der Trennfläche wird erzielt, indem sich in einer vorteilhaften Ausführungsform die Trennflächenpassivierungsschicht über die gesamte Trennfläche erstreckt.

Das erfindungsgemäße Halbleiterbauelement weist den Vorteil auf, dass aufgrund der Passivierung der Trennfläche durch die Trennflächenpassivierungsschicht die Fläche des Halbleiterbauelementes effizient genutzt werden kann und somit der Emitter bis zur Trennfläche heranreichen kann. Insbesondere vorbekannte Methoden zum Vermeiden negativer Einflüsse einer Trennfläche, welche eine Isolierung mittels Isolierungsgräben und/oder Beabstandung des pn-Überganges durch Ausbilden von Emitterfenstern zu der Trennfläche vorgesehen haben, sind nicht oder zumindest nicht zwingend notwendig. Zwar kann der positive Effekt gesteigert werden, indem der pn-Übergang nicht unmittelbar bis an die Trennfläche heranreicht, zu einer solchen Steigerung ist jedoch eine geringfügige Beabstandung ausreichend. Erfindungsgemäß grenzt der pn-Übergang an die Trennfläche an. Hierdurch ergibt sich ein vereinfachtes Herstellungsverfahren.

Die Trennflächenpassivierungsschicht ist bevorzugt als dielektrische Schicht ausgebildet, insbesondere als Aluminiumoxidschicht, als Siliziumnitridschicht oder als Siliziumoxinitridschicht. Diese Schichten können in an sich bekannter Weise erzeugt werden und mit hohen Flächenladungsdichten versehen werden. Insbesondere liegt es im Rahmen der Erfindung, die Trennflächenpassivierungsschicht mit einem der nachfolgenden Verfahren auszubilden:
- CVD (siehe nachfolgend);
- ALD (siehe nachfolgend);
- Drucktechnologien, insbesondere ein Druck mittels Siebdruck, Inkjet, Extrusion oder Dispenser;
- Spray-Coating;
- Aufbringen von Schichtmaterial mittels eines Mediums auf die Trennfläche;

Das Halbleiterbauelement ist als fotovoltaische Solarzelle ausgebildet. Denn insbesondere bei fotovoltaischen Solarzellen sind hohe Lebensdauern von Minoritätsladungsträgern in Emitter und Basis für hohe Wirkungsgrade notwendig, sodass hier die Passivierung einer Trennfläche eine besondere Relevanz hat.

Vorteilhafterweise ist daher das Halbleiterbauelement als fotovoltaische Solarzelle ausgebildet, welche zumindest eine Siliziumschicht aufweist, in welcher zumindest die Basis ausgebildet ist. Es liegt hierbei im Rahmen der Erfindung, dass sowohl Emitter als auch Basis in der Siliziumschicht ausgebildet sind. Ebenso liegt das Anordnen einer separaten Schicht, insbesondere einer separaten Siliziumschicht, zum Ausbilden des Emitters an der Basis im Rahmen der Erfindung.

Vorteilhafterweise erfolgt die Trennung des Halbleiterbauelementes an der Trennfläche derart, dass eine Schädigungszone mit einer geringen Tiefe entsteht. Insbesondere ist es vorteilhaft, dass das Halbleiterbauelement an der Trennfläche eine Schädigungszone mit einer Ladungsträgerlebensdauer zumindest in der Basis < 1 µs aufweist, wobei die Schädigungszone senkrecht zur Trennfläche eine Dicke < 20 nm aufweist. Insbesondere ist es vorteilhaft, dass die Ladungsträgerlebensdauer zumindest in der Basis in einem an die Schädigungszone angrenzenden Bereiche eine Ladungsträgerlebensdauer > 10 µs aufweist, wie bei fotovoltaischen Solarzellen üblich.

Das erfindungsgemäße Verfahren zum Vereinzeln eines Halbleiterbauelementes mit einem pn-Übergang weist folgende Verfahrensschritte auf:
In einem Verfahrensschritt A erfolgt ein Bereitstellen eines Halbleiterbauelementes, welches zumindest einen Emitter und zumindest eine Basis aufweist, wobei zwischen Emitter und Basis ein pn-Übergang ausgebildet ist.

In einem Verfahrensschritt B erfolgt ein Vereinzeln des Halbleiterbauelementes durch Auftrennen in zumindest zwei Teilelemente an zumindest einer Trennfläche. In Verfahrensschritt B erfolgt das Vereinzeln derart, dass der pn-Übergang an die Trennfläche angrenzt, wobei vor Verfahrensschritt B an einer Vorder- und/oder einer Rückseite des Halbleiterbauelementes eine passivierende Schicht aufgebracht wird und wobei vor Verfahrensschritt B an einer Vorder- und/oder einer Rückseite des Halbleiterbauelementes eine oder mehrere metallische Kontaktierungsstrukturen aufgebracht werden, wobei das Halbleiterbauelement als fotovoltaische Solarzelle ausgebildet wird.

Wesentlich ist, dass nach Verfahrensschritt B an der Trennfläche eine Trennflächenpassivierungsschicht angeordnet wird, welche mit einer Flächenladungsdichte mit Betrag größer gleich 10¹² cm⁻² ausgebildet wird. Hierdurch ergeben sich die bei der Beschreibung des erfindungsgemäßen Halbleiterbauelementes genannten Vorteile.

Die Trennflächenpassivierungsschicht ist bevorzugt die gesamte Trennfläche bedeckend ausgebildet, um eine möglichst effiziente Verringerung der negativen Einflüsse der Trennfläche auf die elektronische Güte des Halbleiterbauelementes zu erzielen.

Es liegt im Rahmen der Erfindung, in Verfahrensschritt B das Vereinzeln mittels Trennen des Halbleiterbauelementes mit einer an sich bekannten Methode durchzuführen. Das Vereinzeln des Halbleiterbauelementes im Verfahrensschritt B kann somit in an sich bekannter Weise erfolgen, insbesondere mittels eines oder mehrerer der nachfolgend beschriebenen Verfahren:
a) Verfahren einer Chipsäge (W. P. Mulligan, A. Terao, D. D. Smith, P. J. Verlinden, and R. M. Swanson, "Development of chip-size silicon solar cells", in Proceedings of the 28th IEEE Photovoltaic Specialists Conference, Anchorage, USA, 2000, pp. 158-163);
b) Erzeugen eines Grabens mittels eines Lasers mit nachfolgendem mechanischen Brechen (M. Oswald, M. Turek, J. Schneider, and S. Schönfelder, "Evaluation of silicon solar cell separation techniques for advanced module concepts", in Proceedings of the 28th European Photovoltaic Solar Energy Conference and Exhibition, Paris, France, 2013, pp. 1807-1812);
c) Thermal Laser Separation (TLS): M. Oswald, M. Turek, J. Schneider, and S. Schönfelder, "Evaluation of silicon solar cell separation techniques for advanced module concepts", in Proceedings of the 28th European Photovoltaic Solar Energy Conference and Exhibition, Paris, France, 2013, pp. 1807-1812; S. Eiternick, F. Kaule, H.-U. Zühlke, T. Kießling, M. Grimm, S. Schoenfelder, and M. Turek, "High quality half-cell processing using thermal laser separation", Energy Procedia, vol. 77, pp. 340-345, 2015.
d) Laser induced Cutting (LIC): S. Weinhold, A. Gruner, R. Ebert, J. Schille, and H. Exner, "Study of fast laser induced cutting of silicon materials", in Proc. SPIE 8967, Laser Applications in Microelectronic and Optoelectronic Manufacturing (LAMOM), San Francisco, USA, 2014, 89671J.

Untersuchungen zeigen, dass es insbesondere vorteilhaft ist, das Vereinzeln in Verfahrensschritt B mittels TLS oder LIC auszuführen. Das TLS-Verfahren beruht darauf, dass mittels eines ersten Laserstrahls ein kurzer Lasergraben erzeugt wird, der dann auf Basis von gleichzeitigem Heizen (beispielsweise mittels eines zweiten Laserstrahls) und Kühlen (zum Beispiel mittels eines Luft-Wasser-Gemischs) entlang der zu erzeugenden Kante in beliebiger Richtung mittels eingebrachter thermomechanischer Spannung zu einer Trennung des Wafers führt. Hierdurch ist insbesondere eine Trennfläche unabhängig von der Kristallorientierung des zu trennenden Wafers möglich. Das LIC-Verfahren ist dem TLS-Verfahren recht ähnlich, wobei bei LIC keine aktive Kühlung dem Heizen (beispielsweise durch einen Laserstrahl) nachgeführt wird. Das LIC-Verfahren ist auch unter dem Namen LDC-Verfahren (Laser Direct Cleaving) bekannt.

Das erfindungsgemäße Verfahren weist insbesondere den Vorteil auf, dass das Vereinzeln nach Fertigstellung oder zumindest weitgehender Fertigstellung des Halbleiterbauelementes erfolgen kann. Erfindungsgemäß wird daher vor Verfahrensschritt B an einer Vorder- und/oder Rückseite des Halbleiterbauelementes eine passivierende Schicht aufgebracht. Erfindungsgemäß wurde vor Verfahrensschritt B an einer Vorder- und/oder einer Rückseite des Halbleiterbauelementes eine oder mehrere metallische Kontaktierungsstrukturen zum Zu- und/oder Abführen von Ladungsträgern aufgebracht.

Um die Passivierungsgüte der Trennflächenpassivierungsschicht zu verbessern ist es vorteilhaft, dass nach Aufbringen der Trennflächenpassivierungsschicht eine Temperaturbehandlung der Trennflächenpassivierungsschicht erfolgt, insbesondere eine Erwärmung auf eine Temperatur größer gleich 150 °C für eine Zeitdauer von zumindest 1 min.

Zur Verbesserung der Passivierungsgüte kann es außerdem vorteilhaft sein, dies in einer definierten Atmosphäre, insbesondere in wasserstoffhaltiger Atmosphäre, auszuführen.

Die Temperaturbehandlung kann global erfolgen, indem das gesamte Halbleiterbauelement erwärmt wird. In einer vorteilhaften Ausführungsform erfolgt die Temperaturbehandlung der Trennflächenpassivierungsschicht mittels sukzessiver lokaler Erwärmung, insbesondere mittels eines Lasers. In diesem Fall werden somit nacheinander lokale Teilbereiche der Trennflächenpassivierungsschicht erwärmt, insbesondere bevorzugt, wie zuvor genannt, unter wasserstoffhaltiger Atmosphäre.

Wie zuvor beschrieben, ist das erfindungsgemäße Verfahren insbesondere vorteilhaft zum Vereinzeln von fotovoltaischen Solarzellen anwendbar. Das Halbleiterbauelement ist daher als fotovoltaische Solarzelle ausgebildet, insbesondere wird bevorzugt zumindest die Basis in einer Siliziumschicht ausgebildet.

In einer weiteren vorteilhaften Ausgestaltung ist die Trennflächenpassivierungsschicht zusätzlich an zumindest der Vorder- oder zumindest der Rückseite des Halbleiterbauelementes ausgebildet. Dies weist den Vorteil auf, dass die Trennflächenpassivierungsschicht zusätzlich mit einer weiteren Funktion an Vorder- und/oder Rückseite verwendet werden kann. Insbesondere bei Ausbildung des Halbleiterbauelementes als fotovoltaische Solarzelle kann ein Aufbringen der Trennflächenpassivierungsschicht an der bei Verwendung der Solarzelle der einfallenden Strahlung zugewandten Seite, insbesondere der Vorderseite, als weitere optische Schicht zum Erhöhen der Lichteinkopplung im Solarmodul führen. Bei dem erfindungsgemäßen Verfahren erfolgt daher bevorzugt ein Ausbilden der Trennflächenpassivierungsschicht zusätzlich auf Vorder- und/oder Rückseite des Halbleiterbauelementes, insbesondere während Erzeugen der Trennflächenpassivierungsschicht an der Trennfläche.

Insbesondere ist es vorteilhaft, dass wie zuvor beschrieben, auf zumindest einer Seite des Halbleiterbauelementes eine passivierende Schicht aufgebracht wird und die Trennflächenpassivierungsschicht auf die passivierende Schicht und auf die zu passivierende Trennfläche aufgebracht wird. Insbesondere ist es vorteilhaft, die passivierende Schicht zusätzlich als Ladungsträgerbarrierenschicht auszubilden. Hierdurch wird eine Bildung von ortsfesten Ladungen in der Trennflächenpassivierungsschicht an der Fläche, in welcher die Trennflächenpassivierungsschicht die Ladungsträgerbarrierenschicht bedeckt, vermieden. Dies ist darin begründet, dass die Ladungsträgerbarrierenschicht als Tunnelbarriere wirkt, keine Ladungsträger aus dem Halbleiter in die Trennflächenpassivierungsschicht eindringen können und so die Trennflächenpassivierungsschicht keine ortsfesten Ladungen ausbilden kann. Vorteilhafterweise ist die Ladungsträgerbarrierenschicht als dielektrische Schicht ausgebildet, insbesondere als Siliziumnitridschicht, Siliziumoxidschicht, Siliziumoxinitridschicht oder Aluminiumoxidschicht.

Ein weiterer Vorteil des vorliegenden Verfahrens ist, dass die Trennfläche nicht notwendiger Weise parallel zu einer Vorzugsrichtung, in welcher ein Halbleitersubstrat des Halbleiterbauelementes die schwächsten Bindungen aufweist, liegen muss. Bei einkristallinen Siliziumwafer erfolgt bei Bruch typischerweise eine Bruchlinie in einem 45°-Richtung zu einer Kante des Siliziumwafers, da aufgrund der Kristallorientierung in dieser Richtung geringere Bindungen bestehen. Das vorliegende Verfahren ermöglicht jedoch Trennflächen in beliebigen Winkeln, insbesondere Trennflächen parallel zu einer Kante des Siliziumwafers.

Vorzugsweise ist die Trennfläche daher parallel zu einer Kante des Halbleiterbauelementes, insbesondere, eines Siliziumwafers des Halbleiterbauelementes.

Weitere vorteilhafte Merkmale und Ausführungsformen der vorliegenden Erfindung werden nachfolgend anhand von Ausführungsbeispielen und den Figuren erläutert. Dabei zeigt:
- Figur 1: zwei Ausführungsbeispiele erfindungsgemäßer Halbleiterbauelemente sowie Teilschritte zweier Ausführungsbeispiele erfindungsgemäßer Verfahren und
- Figur 2: eine Draufsicht von oben auf einen Halbleiterwafer zur Verdeutlichung der Position der Trennflächen.

In den Figuren sind schematische, nicht maßstabsgetreue Darstellungen gezeigt. Insbesondere die Breiten und Dicken der einzelnen Schichten entsprechen zur besseren Darstellbarkeit nicht den tatsächlichen Verhältnissen.

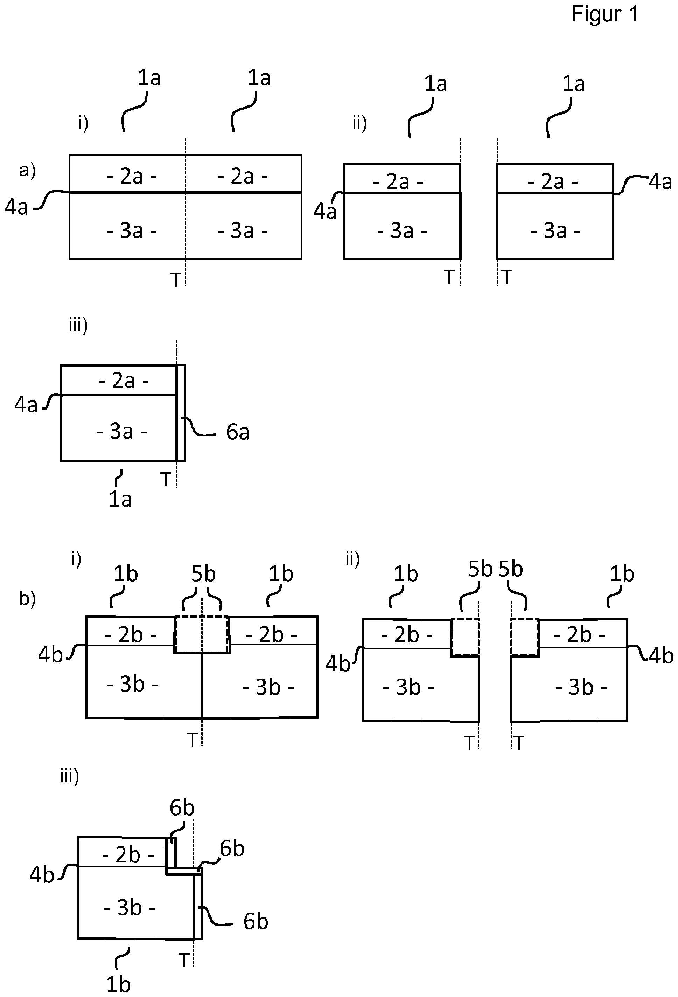

In Figur 1 sind zwei Ausführungsbeispiele A und B jeweils mit Teilschritten eines Ausführungsbeispiels eines erfindungsgemäßen Verfahrens gezeigt. In Figur 1a, iii ist entsprechend ein erstes Ausführungsbeispiel eines erfindungsgemäßen Halbleiterbauelementes und in Figur 1b, iii ein zweites Ausführungsbeispiel eines erfindungsgemäßen Halbleiterbauelementes dargestellt. Das Halbleiterbauelement ist als fotovoltaische Solarzelle ausgebildet.

Anhand der in Figur 1a dargestellten Teilschritte wird das erste Ausführungsbeispiel eines erfindungsgemäßen Verfahrens erläutert:
In einem Verfahrensschritt A wird das Halbleiterbauelement 1a bereitgestellt. Dieses weist vorliegend einen mittels Diffusion aus der Gasphase ausgebildeten Emitter 2a des n-Dotierungstyps und entsprechend eine Basis 3a auf, welche mit einem Dotierstoff des p-Dotierungstyps dotiert ist. Entsprechend bildet sich zwischen Emitter 2a und Basis 3a ein pn-Übergang 4a aus. Emitter und Basis wurden in einem Siliziumwafer ausgebildet. Weiterhin wurden zusätzliche, an sich bekannte Komponenten einer Solarzelle bereits erzeugt: Dies umfasst Passivierungsschichten an der oben liegenden Vorderseite sowie an der unten liegenden Rückseite, Metallisierungsstrukturen an Vorder- und Rückseite zum Abführen von Ladungsträgern sowie Antireflexschichten an der Vorder- und gegebenenfalls Rückseite zum Erhöhen der Lichtabsorption. In einer Abwandlung des Ausführungsbeispiels wird der Emitter mittels Diffusion aus einer vorab aufgebrachten Dotierschicht oder mittels Implantation ausgebildet. Ebenso können die Dotiertypen von Emitter und Basis vertauscht sein.

Anschließend wird in einem Verfahrensschritt B mittels des vorbeschriebenen TLS-Verfahrens ein Vereinzeln durch Auftrennen an der Trennfläche T durchgeführt. Die Trennfläche T steht senkrecht zur Zeichenfläche in Figur 1 und durchdringt somit die Basis 3a sowie Emitter 2a.

Das TLS-Verfahren wird ausgehend von der Rückseite durchgeführt, das heißt, zunächst wird mittels eines Lasers ein Initialgraben an der unten liegenden Rückseite in dem Bereich, in welchem die Trennlinie T die Rückseite schneidet, ausgebildet. Der Initialgraben beginnt an einer Kante des Halbleiterbauelementes. Der Initialgraben erstreckt sich nicht über die gesamte Breite des Halbleiterbauelementes. Typische Initialgräben weisen eine Länge im Bereich 200 µm bis 4 mm auf, typischerweise kleiner 2 mm. Anschließend erfolgt wie zuvor beschrieben mittels gleichzeitigem Heizen und Kühlen ein Auftrennen des Halbleiterbauelementes. In einer Abwandlung des Ausführungsbeispiels erfolgt das TLS-Verfahren ausgehend von der Vorderseite, so dass im Prozess die Solarzelle nicht gedreht werden muss.

Das Ergebnis ist in Figur 1a, ii dargestellt: Es werden somit zwei spiegelbildlich symmetrische Halbleiterbauelemente erzeugt, die jeweils einen pn-Übergang 4a aufweisen, der an die Trennfläche T angrenzt.

Nach Verfahrensschritt B wird an der Trennfläche T eine Trennflächenpassivierungsschicht 6a ausgebildet. Die Ausbildung erfolgt mittels industrietypischer chemischer Gasphasenabscheidung (Englisch: Chemical Vapor Deposition, CVD) oder in einer Abwandlung mittels Atomlagenabscheidung (Englisch: Atomic Layer Deposition, ALD) erfolgen.

Die Trennflächenpassivierungsschicht 6a erstreckt sich somit über die gesamte Trennfläche T. Die Trennflächenpassivierungsschicht ist als Aluminiumoxidschicht mit einer Flächenladungsdichte im Betrag ≥ 10¹² cm⁻², vorliegend -3×10¹² cm⁻² an der Grenzfläche zur Trennfläche T ausgebildet und weist eine Dicke von wenigen Atomlagen über einige wenige nm bis hin zu mehreren 10 nm auf, vorliegend 6 nm.

In Figur 1b ist ein zweites Ausführungsbeispiel eines erfindungsgemäßen Verfahrens gezeigt. Zur Vermeidung von Wiederholungen wird nachfolgend lediglich auf die wesentlichen Unterschiede eingegangen:
Das Halbleiterbauelement 1b weist ebenfalls einen Emitter 2b sowie eine Basis 3b auf, sodass sich zwischen Emitter und Basis ein pn-Übergang 4b ausbildet. Zwischen den Verfahrensschritten A und B wie zuvor beschrieben, das heißt insbesondere vor dem Vereinzeln, erfolgt jedoch in einem Verfahrensschritt B0 das Ausbilden eines Querleitungsvermeidungsbereiches 5b. Wie in Figur 1b, i ersichtlich wird mittels Laserablation ein als Trenngraben ausgebildeter Querleitungsvermeidungsbereich 5b ausgebildet, welcher den Emitter 2b und auch den pn-Übergang 4b vollständig durchdringt. Hierdurch wird eine Querleitung von Ladungsträgern durch den Emitter zu der Trennfläche T vermieden und somit ein die elektronische Güte des Halbleiterbauelementes verringernder negativer Einfluss der Trennfläche zusätzlich verringert.

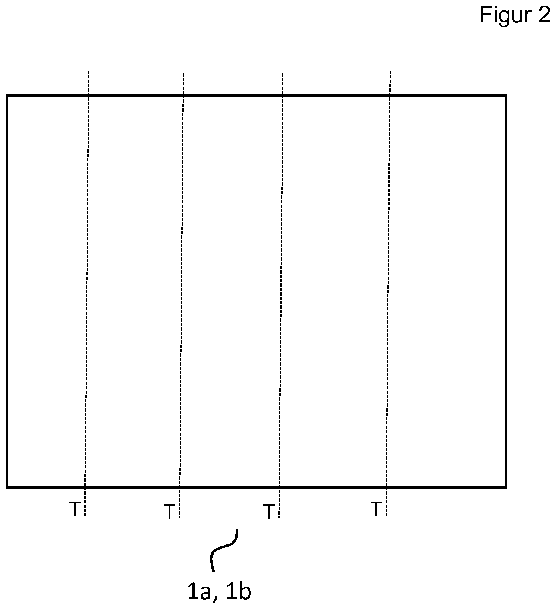

Wie in Figur 1b, 2ii ersichtlich, erfolgt analog zum ersten Ausführungsbeispiel anschließend ein Auftrennen und somit Vereinzeln des Halbleiterbauelementes an der Trennfläche T. In diesem Ausführungsbeispiel erfolgt das Auftrennen mittels des vorbeschriebenen LIC-Verfahrens.

Wie in Figur 1b, 3iii ersichtlich, erfolgt anschließend das Aufbringen der Trennflächenpassivierungsschicht 6b. Diese ist vorliegend als Aluminiumoxidschicht mit einer Flächenladungsdichte im Betrag größer gleich 10¹² cm⁻², vorliegend etwa -3×10¹² cm⁻² an der Grenzfläche zu Basis und Emitter ausgebildet und weist eine Dicke von wenigen Atomlagen über einige wenige nm bis hin zu mehreren 10 nm, vorliegend 6 nm auf. Die Trennflächenpassivierungsschicht 6b wurde mittels ALD erzeugt. Hierdurch erfolgt ein Ausbilden nicht nur an der Trennfläche T, sondern ebenfalls an den Wänden des als Trenngraben ausgebildeten Querleitungsvermeidungsbereiches 5b.

In Figur 1 ist aus Gründen der besseren Darstellbarkeit jeweils lediglich eine Trennfläche dargestellt.

Bei dem Vereinzeln von fotovoltaischen Solarzellen beispielsweise zur Ausbildung von Modulen gemäß der eingangs genannten Schindelungstechnik erfolgt üblicherweise ausgehend von einem Siliziumwafer ein Vereinzeln einer Mehrzahl von Solarzellen.

In Figur 2 ist eine schematische Draufsicht von oben auf einen Siliziumwafer, in welchem fotovoltaische Solarzellen ausgebildet wurden, dargestellt. An mehreren, vorliegend vier, Trennflächen T erfolgt ein Durchführen eines der vorbeschriebenen Verfahren, sodass nach Vereinzeln fünf Halbleiterbauelemente vorliegen.

### Bezugszeichenliste

- 1a, 1b: Halbleiterbauelement
- 2a, 2b: Emitter
- 3a, 3b: Basis
- 4a, 4b: pn-Übergang
- 5b: Querleitungsvermeidungsbereich
- 6a, 6b: Trennflächenpassivierungsschicht
- T: Trennfläche

## Patentansprüche

1. Halbleiterbauelement (1a, 1b) mit
einer Vorder- und einer gegenüberliegenden Rückseite sowie Seitenflächen, sowie zumindest ein Emitter (2a, 2b) und zumindest einer Basis (3a, 3b), wobei zwischen Emitter (2a, 2b) und Basis (3a, 3b) ein pn-Übergang (4a, 4b) ausgebildet ist und der Emitter (2a, 2b) sich parallel zu der Vorder- und/oder Rückseite erstreckt,
wobei der pn-Übergang (4a, 4b) an die Trennfläche (T) angrenzt und das Halbleiterbauelement (1a, 1b) als fotovoltaische Solarzelle ausgebildet ist,
**dadurch gekennzeichnet,**
**dass** zumindest eine Seitenfläche eine passivierte Trennfläche (T) ist, an der eine Trennflächenpassivierungsschicht (6a, 6b) angeordnet ist, welche ortsfeste Ladungen mit einer Flächenladungsdichte an der Trennfläche (T) im Betrag größer gleich 10¹² cm⁻² aufweist, wobei der pn-Übergang (4a, 4b) an die passivierte Trennfläche (T) angrenzt.

2. Halbleiterbauelement (1a, 1b) nach Anspruch 1,
**dadurch gekennzeichnet,**
**dass** sich die Trennflächenpassivierungsschicht (6a, 6b) sich über die gesamte Trennfläche (T) erstreckt.

3. Halbleiterbauelement (1a, 1b) nach einem der vorangegangenen Ansprüche,
**dadurch gekennzeichnet,**
**dass** Trennflächenpassivierungsschicht (6a, 6b) als dielektrische Schicht ausgebildet ist, insbesondere als Aluminiumoxidschicht, als Siliziumnitridschicht oder als Siliziumoxinitridschicht.

4. Halbleiterbauelement (1a, 1b),
**dadurch gekennzeichnet,**
**dass** das Halbleiterbauelement (1a, 1b) als fotovoltaische Solarzelle ausgebildet ist mit zumindest einer Siliziumschicht, in welcher zumindest die Basis (3a, 3b) ausgebildet ist.

5. Halbleiterbauelement (1a, 1b) nach einem der vorangegangenen Ansprüche,
**dadurch gekennzeichnet,**
**dass** das Halbleiterbauelement (1a, 1b) an der Trennfläche (T) eine Schädigungszone mit einer Ladungsträgerlebensdauer zumindest in der Basis (3a, 3b) kleiner 1 µs aufweist, wobei die Schädigungszone senkrecht zur Trennfläche (T) eine Dicke kleiner 20 nm aufweist, insbesondere, dass die Ladungsträgerlebensdauer zumindest in der Basis (3a, 3b) in einem an die Schädigungszone angrenzenden Bereich eine Ladungsträgerlebensdauer größer 10 µs aufweist.

6. Verfahren zum Vereinzeln eines Halbleiterbauelementes (1a, 1b) mit einem pn-Übergang (4a, 4b), mit den Verfahrensschritten
A. Bereitstellen eines Halbleiterbauelementes (1a, 1b), welches zumindest einen Emitter (2a, 2b) und zumindest eine Basis (3a, 3b) aufweist, wobei zwischen Emitter (2a, 2b) und Basis (3a, 3b) ein pn-Übergang (4a, 4b) ausgebildet ist,
B. Vereinzeln des Halbleiterbauelementes (1a, 1b) durch Auftrennen in zumindest zwei Teilelemente an zumindest einer Trennfläche (T),
wobei in Verfahrensschritt B das Vereinzeln derart erfolgt, dass der pn-Übergang (4a, 4b) an die Trennfläche (T) angrenzt,
wobei vor Verfahrensschritt B an einer Vorder- und/oder einer Rückseite des Halbleiterbauelementes (1a, 1b) eine passivierende Schicht aufgebracht wird und wobei vor Verfahrensschritt B an einer Vorder- und/oder
einer Rückseite des Halbleiterbauelementes (1a, 1b) eine oder mehrere metallische Kontaktierungsstrukturen aufgebracht werden,
wobei das Halbleiterbauelement (1a, 1b) als fotovoltaische Solarzelle ausgebildet wird,
**dadurch gekennzeichnet,**
**dass** nach Verfahrensschritt B an der Trennfläche (T) eine Trennflächenpassivierungsschicht (6a, 6b) angeordnet wird, welche mit ortsfesten Ladungen mit einer Flächenladungsdichte im Betrag größer gleich 10¹² cm⁻² ausgebildet wird.

7. Verfahren nach Anspruch 6,
**dadurch gekennzeichnet,**
**dass** die Trennflächenpassivierungsschicht (6a, 6b) die gesamte Trennfläche (T) bedeckend ausgebildet wird.

8. Verfahren nach einem der Ansprüche 6 bis 7,
**dadurch gekennzeichnet,**
**dass** in Verfahrensschritt B das Vereinzeln mittels thermischem Laserseparieren (TLS, LIC oder LDC) erfolgt.

9. Verfahren nach einem der Ansprüche 6 bis 8,
**dadurch gekennzeichnet,**
**dass** nach Aufbringen der Trennflächenpassivierungsschicht (6a, 6b) eine Temperaturbehandlung der Trennflächenpassivierungsschicht (6a, 6b) erfolgt, insbesondere ein Erwärmen auf eine Temperatur größer gleich 150 °C für eine Zeitdauer von zumindest 1 min.

10. Verfahren nach Anspruch 9,
**dadurch gekennzeichnet,**
**dass** die Temperaturbehandlung mittels sukzessiver lokaler Erwärmung erfolgt, insbesondere mittels eines Lasers.

11. Verfahren nach Anspruch 10,
**dadurch gekennzeichnet,**
**dass** die Temperaturbehandlung innerhalb einer wasserstoffhaltigen Atmosphäre, insbesondere einer Wasserstoffatmosphäre oder einer Wasserstoff/Stickstoff-Atmosphäre durchgeführt wird.

12. Verfahren nach einem der vorangegangenen Ansprüche 6 bis 11,
**dadurch gekennzeichnet,**
**dass** die Trennflächenpassivierungsschicht zusätzlich an zumindest einer Seite von Vorder- oder Rückseite des Halbleiterbauelementes, bevorzugt an der Vorderseite aufgebracht wird.

13. Verfahren nach einem der Ansprüche 6 bis 11,
**dadurch gekennzeichnet,**
**dass** zumindest die Basis (3a, 3b) in einer Siliziumschicht ausgebildet wird.

## Claims

1. Semiconductor component (1a, 1b) with:
a front side and an opposite back side as well as side faces, as well as at least one emitter (2a, 2b) and at least one base (3a, 3b), wherein a pn junction (4a, 4b) is formed between the emitter (2a, 2b) and base (3a, 3b) and the emitter (2a, 2b) extends parallel to the front side and/or back side,
wherein the pn junction (4a, 4b) is adjacent to the separating surface (T) and the semiconductor component (1a, 1b) is formed as a photovoltaic solar cell,
**characterized in that** at least one side face is a passivated separating surface (T) on which a separating surface passivation layer (6a, 6b) is arranged which has fixed charges with a surface charge density at the separating surface (T) which is greater than or equal to 10¹²cm⁻², the pn junction (4a, 4b) being adjacent to the passivated separating surface (T).

2. Semiconductor component (1a, 1b) according to claim 1,
**characterized in that**
the separating surface passivation layer (6a, 6b) extends over the entire separating surface (T).

3. Semiconductor component (1a, 1b) according to any one of the preceding claims,
**characterized in that**
the separating surface passivation layer (6a, 6b) is formed as a dielectric layer, in particular an aluminum oxide layer, silicon nitride layer or silicon oxynitride layer.

4. Semiconductor component (1a, 1b),
**characterized in that**
the semiconductor component (1a, 1b) is formed as a photovoltaic solar cell with at least one silicon layer, in which at least the base (3a, 3b) is formed.

5. Semiconductor component (1a, 1b) according to any one of the preceding claims, **characterized in that**
the semiconductor component (1a, 1b) has a damage zone at the separating surface (T) with a charge carrier lifetime of at least less than 1 µs in the base (3a, 3b), wherein the damage zone perpendicular to the separating surface (T) has a thickness of less than 20 nm, in particular **in that** the charge carrier lifetime, at least in the base (3a, 3b), has a charge carrier lifetime of more than 10 µs in an area adjoining the damage zone.

6. Method for singulating a semiconductor component (1a, 1b) with a pn junction (4a, 4b), with the method steps:
A. providing a semiconductor component (1a, 1b) which has at least one emitter (2a, 2b) and at least one base (3a, 3b), wherein a pn junction (4a, 4b) is formed between the emitter (2a, 2b) and base (3a, 3b),
B. singulating the semiconductor component (1a, 1b) by separating into at least two part elements at at least one separating surface (T),
wherein in method step B the singulation occurs in such a way that the pn-junction (4a, 4b) is adjacent to the separating surface (T),
wherein before method step B a passivating layer is applied to a front and/or a rear side of the semiconductor component (1a, 1b) and wherein before method step B one or more metallic
contacting structures are applied to a front side and/or a rear side of the semiconductor component (1a, 1b),
wherein the semiconductor component (1a, 1b) is formed as a photovoltaic solar cell,
**characterized in that**
after method step B a separating surface passivation layer (6a, 6b) is arranged on the separating surface (T), which layer is formed with fixed charges with a surface charge denisty which is greater than or equal to 10¹² cm⁻².

7. Method according to claim 6,
**characterized in that**
the separating surface passivation layer (6a, 6b) is formed to cover the entire separating surface (T).

8. Method according to any one of claims 6 to 7,
**characterized in that**
in method step B the singulation occurs by means of thermal laser separation (TLS, LIC or LDC).

9. Method according to any one of claims 6 to 8,
**characterized in that**
following the application of the separating surface passivation layer (6a, 6b), a temperature treatment of the separating surface passivation layer (6a, 6b) occurs, in particular heating to a temperature that is greater than or equal to 150°C for a period of at least 1 minute.

10. Method according to claim 9,
**characterized in that**
the temperature treatment occurs by means of successive local heating, in particular by means of a laser.

11. Method according to claim 10,
**characterized in that**
the temperature treatment is performed within a hydrogen-containing atmosphere, in particular a hydrogen atmosphere or a hydrogen/nitrogen atmosphere.

12. Method according to any one of the preceding claims 6 to 11,
**characterized in that**
the separating surface passivation layer is additionally applied to at least one side of a front side or back side of the semiconductor component, preferably on the front side.

13. Method according to any one of claims 6 to 11,
**characterized in that**
at least the base (3a, 3b) is formed in a silicon layer.

## Revendications

1. Composant semi-conducteur (1a, 1b) avec
un côté avant et un côté arrière opposé ainsi que des surfaces latérales, ainsi qu'au moins un émetteur (2a, 2b) et au moins une base (3a, 3b), dans lequel une transition pn (4a, 4b) est formée entre l'émetteur (2a, 2b) et la base (3a, 3b), et l'émetteur (2a, 2b) s'étend parallèlement au côté avant et/ou arrière,
dans lequel la transition pn (4a, 4b) est contigüe à la surface de séparation (T), et le composant semi-conducteur (1a, 1b) est formé comme cellule solaire photovoltaïque,
**caractérisé en ce qu'**au moins une surface latérale est une surface de séparation (T) passivée au niveau de laquelle une couche de passivation de surface de séparation (6a, 6b) est agencée, laquelle couche présente des charges fixes avec une intensité de charge superficielle au niveau de la surface de séparation (T) qui est supérieure ou égale à 10¹²cm⁻², dans lequel la transition pn (4a, 4b) est contiguë à la surface de séparation (T) passivée.

2. Composant semi-conducteur (1a, 1b) selon la revendication 1,
**caractérisé en ce que**
la couche de passivation de surface de séparation (6a, 6b) s'étend au-dessus de la surface de séparation (T) entière.

3. Composant semi-conducteur (1a, 1b) selon l'une quelconque des revendications précédentes,
**caractérisé en ce que**
la couche de passivation de surface de séparation (6a, 6b) est formée comme couche diélectrique, en particulier comme couche d'oxyde d'aluminium, comme couche de nitrure de silicium ou comme couche d'oxynitrure de silicium.

4. Composant semi-conducteur (1a, 1b),
**caractérisé en ce que**
le composant semi-conducteur (1a, 1b) est formé comme cellule solaire photovoltaïque avec au moins une couche de silicium dans laquelle au moins la base (3a, 3b) est formée.

5. Composant semi-conducteur (1a, 1b) selon l'une quelconque des revendications précédentes,
**caractérisé en ce que**
le composant semi-conducteur (1a ,1b) présente au niveau de la surface de séparation (T) une zone d'endommagement avec une durée de vie de porteur de charge au moins dans la base (3a, 3b) inférieure à 1 µs, dans lequel la zone d'endommagement présente perpendiculairement à la surface de séparation (T) une épaisseur inférieure à 20 nm, en particulier **en ce que** la durée de vie de porteur de charge présente, au moins dans la base (3a, 3b), une durée de vie de porteur de charge supérieure à 10 µs dans une zone contigüe à la zone d'endommagement.

6. Procédé de séparation d'un composant semi-conducteur (1a ,1b) avec une transition pn (4a, 4b), avec les étapes de procédé suivantes
A. la fourniture d'un composant semi-conducteur (1a, 1b) qui présente au moins un émetteur (2a, 2b) et au moins une base (3a, 3b), dans lequel une transition pn (4a, 4b) est formée entre l'émetteur (2a, 2b) et la base (3a, 3b),
B. la séparation du composant semi-conducteur (1a, 1b) par séparation en au moins deux éléments partiels au niveau d'au moins une surface de séparation (T),
dans lequel dans l'étape de procédé B, la séparation est effectuée de telle manière que la transition pn soit contiguë à la surface de séparation (T),
dans lequel avant l'étape de procédé B, une couche de passivation est appliquée au niveau d'un côté avant et/ou arrière du composant semi-conducteur (1a, 1b) et dans lequel avant l'étape de procédé B au niveau d'un côté avant et/ou
arrière du composant semi-conducteur (1a, 1b), une ou plusieurs structures de mise en contact métalliques sont appliquées,
dans lequel le composant semi-conducteur (1a, 1b) est formé comme cellule solaire photovoltaïque,
**caractérisé en ce que**
après l'étape de procédé B, une couche de passivation de surface de séparation (6a, 6b) est agencée au niveau de la surface de séparation (T), couche qui est formée avec des charges fixes avec une épaisseur de charge superficielle qui est supérieure ou égale à 10¹² cm⁻².

7. Procédé selon la revendication 6,
**caractérisé en ce que**
la couche de passivation de surface de séparation (6a, 6b) est formée de manière à recouvrir la surface de séparation (T) entière.

8. Procédé selon l'une quelconque des revendications 6 à 7,
**caractérisé en ce que**
dans l'étape de procédé B, la séparation est effectuée au moyen d'une séparation au laser thermique (TLS, LIC ou LDC).

9. Procédé selon l'une quelconque des revendications 6 à 8,
**caractérisé en ce que**
après l'application de la couche de passivation de surface de séparation (6a, 6b), un traitement en température de la couche de passivation de surface de séparation (6a, 6b) est effectué, en particulier un chauffage à une température supérieure ou égale à 150 °C pour une durée d'au moins 1 min.

10. Procédé selon la revendication 9,
**caractérisé en ce que**
le traitement en température est effectué au moyen d'un chauffage local successif, en particulier au moyen d'un laser.

11. Procédé selon la revendication 10,
**caractérisé en ce que**
le traitement en température est exécuté dans une atmosphère contenant de l'hydrogène, en particulier une atmosphère d'hydrogène ou une atmosphère d'hydrogène/d'azote.

12. Procédé selon l'une quelconque des revendications précédentes 6 à 11,
**caractérisé en ce que**
la couche de passivation de surface de séparation est en outre appliquée sur au moins un côté du côté avant ou arrière du composant semi-conducteur, de préférence sur le côté avant.

13. Procédé selon l'une quelconque des revendications 6 à 11,
**caractérisé en ce que**
au moins la base (3a, 3b) est formée dans une couche de silicium.
